# EUROPEAN PATENT APPLICATION

(11) **EP 4 776 466 A1**
(43) Date of publication of application: **15.07.2026**
(21) Application number: 25841817.7
(22) Date of filing: 14.02.2025
(51) Int. Cl.: H02J 7/00, H02J 50/00

(54) **WIRELESS CHARGING MODULE WITH POWER SWITCHING, AND CONTROL METHOD THEREFOR**

(30) Priority: 06.11.2024 US 202463716729 P
(71) Applicant: Delta Electronics Inc., Taoyuan City 320023 (TW)
(72) Inventor: CHO, Hsin-Lin, Taoyuan City 320023 (TW); LO, Ri-Long, Taoyuan City 320023 (TW); LI, Chun-Yeh, Taoyuan City 320023 (TW); PWU, Jong-Wei, Taoyuan City 320023 (TW)
(74) Representative: 2K Patent Partnerschaft mbB
(86) International application number: PCT/CN2025/077392
(87) International publication number: WO 2026/097721

(57) **Abstract**

A wireless charging module with power switching and a control method thereof. The wireless charging module includes a charging base and a wireless charging pad. The charging base includes a seat body and a first connector. The seat body has an accommodation region. The first connector is exposed in the accommodation region. The wireless charging pad is detachably disposed in the accommodation region. The wireless charging pad includes a controller unit and a second connector. The controller unit is electrically connected to the second connector. The first connector and the second connector are configured to be mated or separated. When the controller unit detects that the first connector and the second connector are separated, the controller unit controls the wireless charging pad to output a first charging power. When the controller unit detects that the first connector and the second connector are mated, the controller unit controls the wireless charging pad to output a second charging power, the second charging power being greater than or equal to the first charging power.

## Description

### CROSS-REFERENCE TO RELATED APPLICATION

This patent application claims the benefit of United States Provisional Patent Application No. 63/716,729, entitled "WIRELESS CHARGING DEVICE," filed November 06, 2024. The entire content of the aforementioned application is incorporated herein by reference.

### TECHNICAL FIELD

The present disclosure relates to a wireless charger, and more particularly to a wireless charging module with power switching and its control method.

### DESCRIPTION OF RELATED ART

Wireless chargers are primarily used for wirelessly charging multiple devices such as iPhones, Apple Watches, and other smartphones and watches. Wireless chargers on the market are mainly divided into wireless charging pads and wireless charging bases. Wireless charging pads offer portability, whereas wireless charging bases provide fast charging, allowing users to select and purchase according to their needs.

However, wireless charging pads have drawbacks, such as inability to actively dissipate heat, which easily causes the product to overheat, and inability to maintain maximum power output, leading to longer charging times. Wireless charging bases, on the other hand, tend to be larger in size and less portable. Therefore, developing a wireless charger that overcomes these drawbacks while combining the advantages of both wireless charging pads and wireless charging bases has become a focus of research and development for charger manufacturers.

In view of the above drawbacks, the inventor proposes this disclosure based on his expert knowledge and elaborate researches in order to solve the problems of related art.

### SUMMARY OF THE INVENTION

The disclosure is directed to a wireless charging module with power switching and a control method thereof. When the wireless charging pad is used alone, or when the wireless charging pad is used together with a charging base, the wireless charging coil may output different charging powers, thereby improving the convenience of using the wireless charging module.

One of the exemplary embodiments provides a wireless charging module with power switching for an external power source. The wireless charging module includes a charging base and a wireless charging pad. The charging base includes a base body, a fan and a first connector mounted to the base body. The base body has an accommodation region. The fan is disposed corresponding to the accommodation region, and the first connector is exposed in the accommodation region. The wireless charging pad is detachably disposed in the accommodation region. The wireless charging pad includes a pad body, a wireless charging coil and a controller unit mounted inside the pad body, and a second connector and a third connector are mounted outside the pad body. The controller unit is electrically connected to the wireless charging coil, the second connector, and the third connector. The first connector is mated with or separable from the second connector, and the third connector is mated with or separable from the external power source. When the controller unit detects that the first connector is separated from the second connector, the controller unit controls the wireless charging coil to output a first charging power. When the controller unit detects that the first connector is mated with the second connector, the controller unit controls the wireless charging coil to output a second charging power, the second charging power being greater than or equal to the first charging power.

One of the exemplary embodiments provides a control method for a wireless charging module with power switching, applicable to an external power source, including a charging base and a wireless charging pad. The charging base includes an accommodation region and a first connector. The wireless charging pad includes a wireless charging coil, a controller unit, and a second connector. The first connector is exposed to the accommodation region. The method includes: a) electrically connecting the wireless charging pad to the external power source and detachably disposing the wireless charging pad in the accommodation region; and b) when the controller unit detects that the first connector is separated from the second connector, controlling the wireless charging coil to output a first charging power, and when the controller unit detects that the first connector is mated with the second connector, controlling the wireless charging coil to output a second charging power, the second charging power being greater than or equal to the first charging power.

Accordingly, the wireless charging module of the present disclosure is capable of automatically switching the charging power according to the operational requirements of using the wireless charging pad alone or using the wireless charging pad in combination with the charging base. Meanwhile, when operating at a higher charging power, active heat dissipation components of the charging base, such as the fan, are activated to dissipate heat from the wireless charging pad. Therefore, the wireless charging module provides the advantages of automatically switching charging power based on operational needs, convenient portability, fast charging, and high heat-dissipation efficiency.

### BRIEF DESCRIPTION OF THE DRAWINGS

FIG. 1 is an exploded perspective view of the wireless charging module of the present disclosure.
FIG. 2 is a perspective assembly view of the wireless charging module of the present disclosure.
FIG. 3 is a perspective schematic view of the operation of the wireless charging module of the present disclosure.
FIG. 4 is another perspective schematic view of the operation of the wireless charging module of the present disclosure.
FIG. 5 is a perspective schematic view of the operation of the wireless charging pad of the present disclosure.
FIG. 6 is a block diagram of the wireless charging module of the present disclosure.
FIG. 7 is a control diagram of the wireless charging module of the present disclosure.
FIG. 8 is a circuit diagram of the wireless charging module of the present disclosure.
FIG. 9 is a flowchart of the control method of the wireless charging module of the present disclosure.
FIG. 10 is an exploded perspective view of another embodiment of the wireless charging module of the present disclosure.
FIG. 11 is a perspective assembly view of another embodiment of the wireless charging module of the present disclosure.
FIG. 12 is a perspective schematic view of the operation of another embodiment of the wireless charging module of the present disclosure.
FIG. 13 is a cross-sectional view of the operation of another embodiment of the wireless charging module of the present disclosure.
FIG. 14 is a block diagram of still another embodiment of the wireless charging module of the present disclosure.

### DESCRIPTION OF REFERENCE NUMERALS

10 : wireless charging module
1 : charging base
11 : base body
111 : accommodation region
112 : recessed slot
113 : pad-receiving slot
114 : connector-receiving slot
12 : fan
13 : first connector
14 : cooling chip
15 : buck converter
16 : heat-dissipating fin
17 : processor unit
2 : wireless charging pad
21: pad body
22 : wireless charging coil
23 : controller unit
24 : second connector
25 : third connector
3 : trapezoidal base body
31 : upright inclined wall
32 : ventilation opening
4 : rectangular base body
41: air inlet
42 : air outlet
100 : external power source
200 : mobile device
300 : vehicle system
S1~S3 : step

### DETAILED DESCRIPTION

The technical contents of this disclosure will become apparent with the detailed description of embodiments accompanied with the illustration of related drawings as follows. It is intended that the embodiments and drawings disclosed herein are to be considered illustrative rather than restrictive.

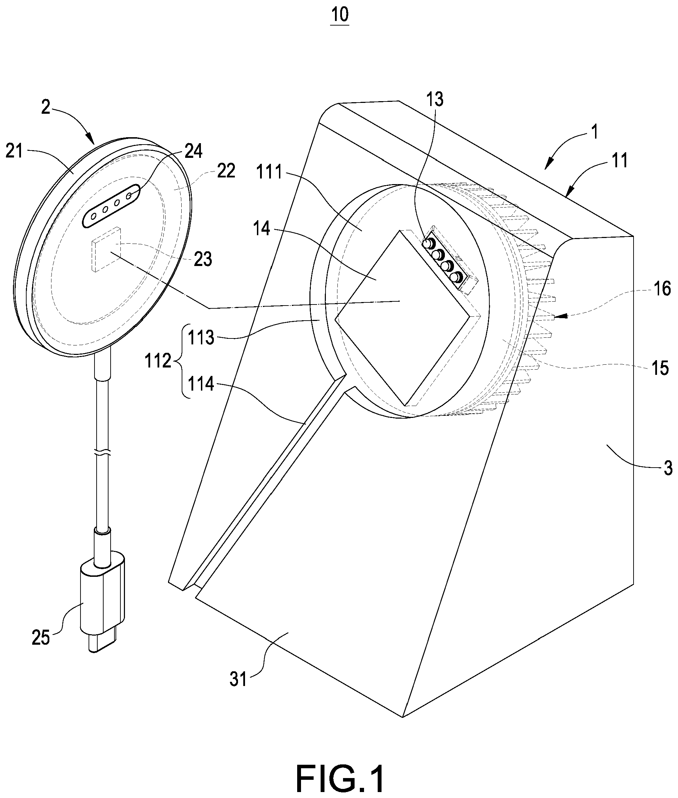

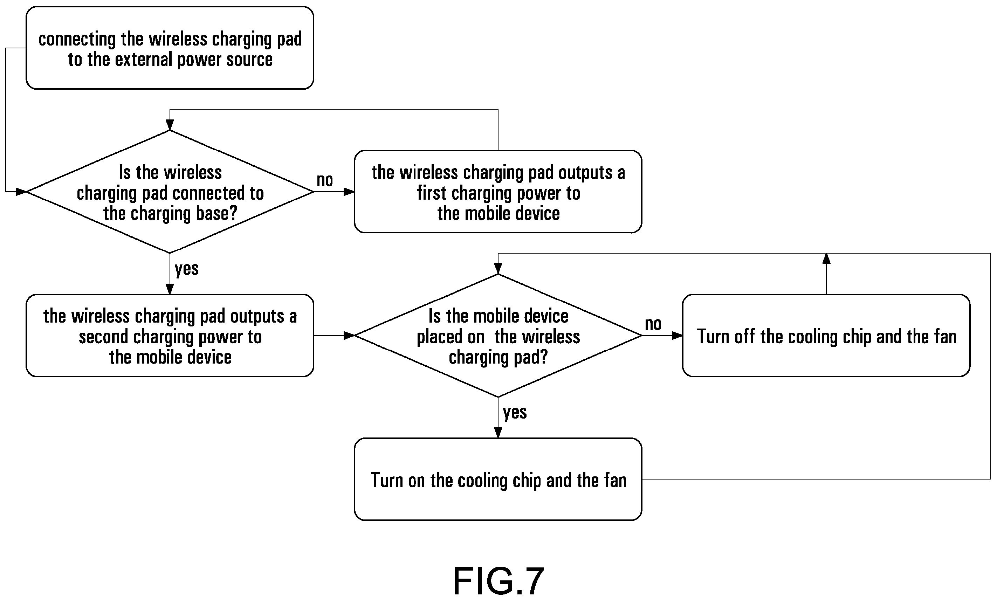

Referring to FIGS. 1 to 9, the present disclosure provides a wireless charging module with power switching and a control method thereof, applicable to an external power source 100 and mobile devices 200, such as smartphones or tablets. The wireless charging module 10 mainly includes a charging base 1 and a wireless charging pad 2.

As shown in FIGS. 1 to 4, the charging base 1 includes a base body 11, and a fan 12, a first connector 13, a cooling chip 14, a buck converter 15, and a set of heat-dissipating fins 16 mounted on the base body 11. The fan 12, the cooling chip 14, and the buck converter 15 are installed inside the base body 11. The base body 11 is formed with an accommodation region 111, where the fan 12 is disposed corresponding to the accommodation region 111. The first connector 13 is exposed from the accommodation region 111, and the cooling chip 14 is attached to the accommodation region 111. The buck converter 15 is electrically connected to the fan 12 and the cooling chip 14 and includes a circuit board and circuitry disposed on the circuit board. The heat-dissipating fins 16 are mounted inside the base body 11, thermally attached to the cooling chip 14, and arranged around the fan 12. The heat-dissipating fins 16 are configured to absorb heat from the cooling chip 14 and dissipate the heat to the surrounding environment.

As shown in FIGS. 1 to 5, the wireless charging pad 2 is detachably disposed in the accommodation region 111. The wireless charging pad 2 includes a pad body 21; a wireless charging coil 22 and a controller unit 23 mounted inside the pad body 21; and a second connector 24 and a third connector 25 mounted outside the pad body 21. The controller unit 23 is electrically connected to the wireless charging coil 22, the second connector 24, and the third connector 25.

Additionally, the first connector 13 and the second connector 24 are capable of being mated with or separated from each other, and the third connector 25 is capable of being mated with or separated from the external power source 100. In the present embodiment, the first connector 13 and the second connector 24 respectively serve as the male and female ends of a pogo pin, and the third connector 25 is a Type-C connector; however, the disclosure is not limited thereto.

When the controller unit 23 detects that the first connector 13 and the second connector 24 are separated, it controls the wireless charging coil 22 to output a first charging power. When the controller unit 23 detects that the first connector 13 and the second connector 24 are mated, it controls the wireless charging coil 22 to output a second charging power, the second charging power being greater than or equal to the first charging power.

The detailed description is as follows. The base body 11 of this embodiment is provided with a recessed slot 112. The wireless charging pad 2 may be assembled to or detached from the recessed slot 112 through structural engagement such as shape matching, protrusion- and-recess engagement, or magnetic attraction, thereby allowing the wireless charging pad 2 to be detachably embedded in the recessed slot 112. The accommodation region 111 is formed on the inner bottom wall of the recessed slot 112.

Additionally, the recessed slot 112 of this embodiment includes a pad-receiving slot 113 having a shape corresponding to that of the pad body 21, and a connector-receiving slot 114 having a shape corresponding to that of the third connector 25, but this is not limited thereto. The recessed slot 112 may include only the pad-receiving slot 113 without the connector-receiving slot 114.

Moreover, in this embodiment, the base body 11 is a trapezoidal base body 3, but this is not limited thereto. One side of the outer periphery of the trapezoidal base body 3 is provided with an upright inclined wall 31, and a ventilation opening 32 is formed at the bottom thereof. The recessed slot 112 is formed on the outer side surface of the upright inclined wall 31. The fan 12 and the heat-dissipating fin 16 are fixed to the inner side surface of the upright inclined wall 31. The cooling chip 14 is interposed among the upright inclined wall 31, the fan 12, and the heat-dissipating fin 16, and is exposed to the accommodation region 111.

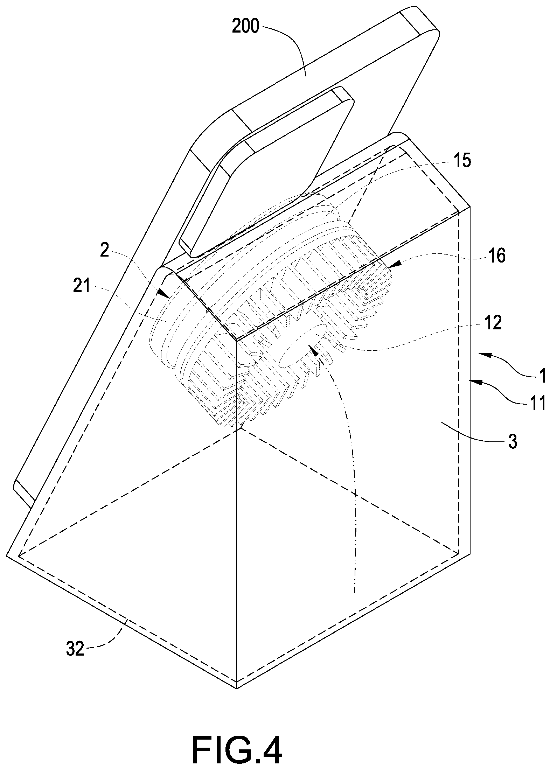

As shown in FIG. 4, in this embodiment, the fan 12 is an axial fan configured to generate an airflow, indicated by dashed lines with arrows in the figure, that sequentially enters the axial fan through the ventilation opening 32 and is then blown toward the accommodation region 111, thereby dissipating heat from the cooling chip 14 and the heat-dissipating fin 16.

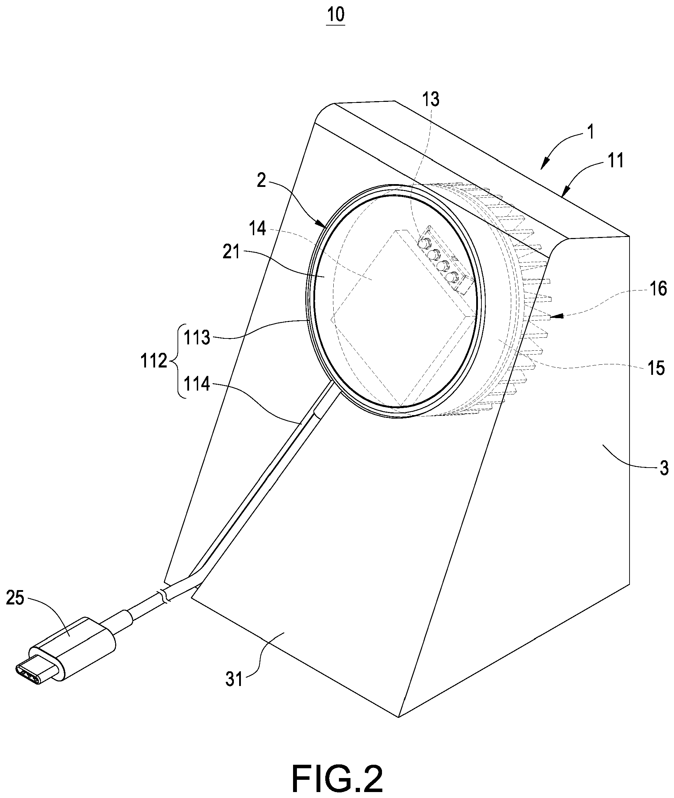

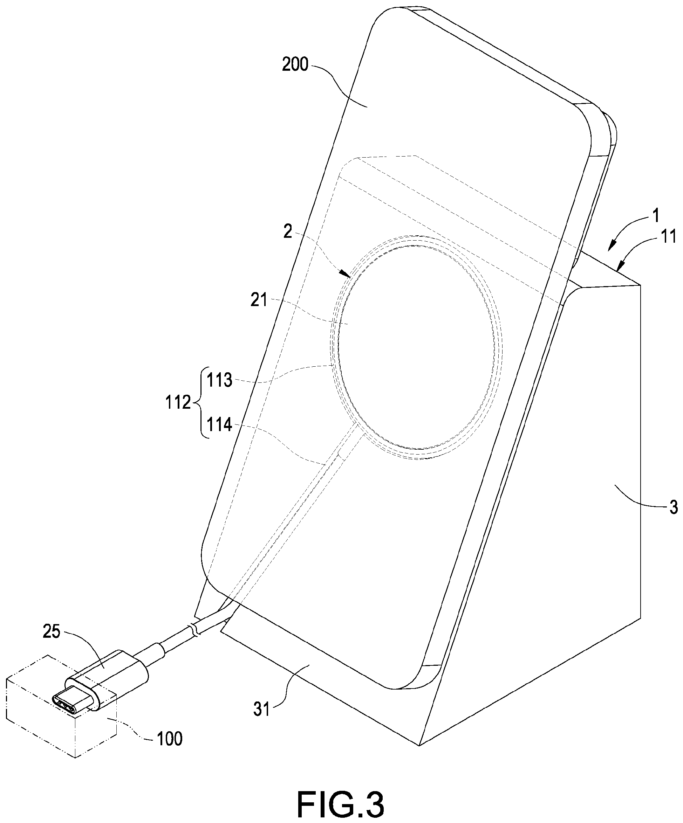

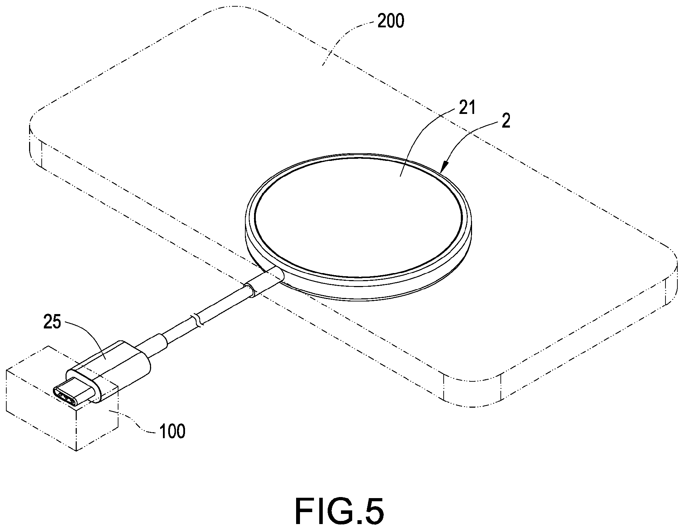

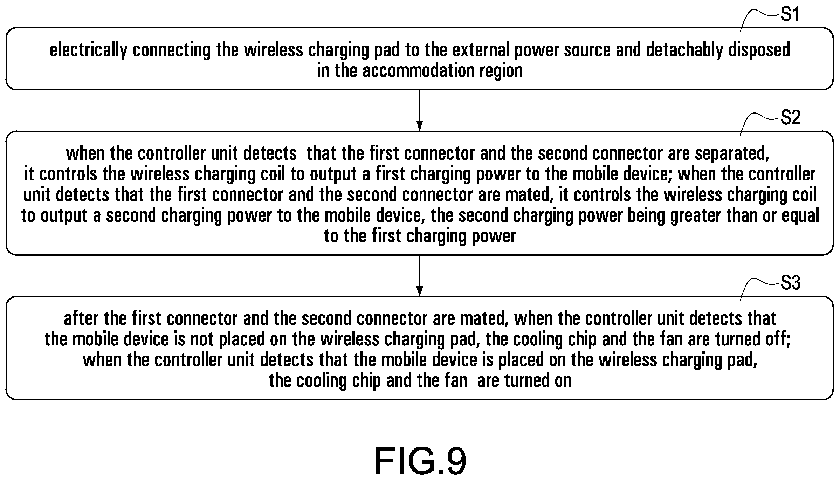

As shown in FIG. 9, the steps of the control method of the wireless charging module 10 of the present disclosure are as follows. First, as shown in step S1 of FIG. 9 and in FIGS. 1 to 5, the wireless charging pad 2 is electrically connected to the external power source 100 and detachably disposed in the accommodation region 111. Further details are as follows, as shown in FIGS. 1 and 5, the reference state is when the wireless charging pad 2 is detached from the accommodation region 111; as shown in FIGS. 2 to 4, the reference state is when the wireless charging pad 2 is assembled in the accommodation region 111; and as shown in FIGS. 3 and 5, the third connector 25 is mated with the external power source 100, which represents the reference state in which the wireless charging pad 2 is connected to the external power source 100.

Second, as shown in step S2 of FIG. 9 and in FIGS. 1 to 8, when the controller unit 23 detects via a first sensor that the first connector 13 and the second connector 24 are separated, it controls the wireless charging coil 22 to output a first charging power to the mobile device 200. When the controller unit 23 detects via the first sensor that the first connector 13 and the second connector 24 are mated, it controls the wireless charging coil 22 to output a second charging power to the mobile device 200, the second charging power being greater than or equal to the first charging power.

In this embodiment, the first sensor may be a current or voltage sensor installed corresponding to the first connector 13. Whether the first connector 13 and the second connector 24 are mated is determined by detecting changes in current or voltage via the current or voltage sensor, but the first sensor is not limited to this.

Furthermore, in this embodiment, the first charging power is less than 25 W, and the second charging power is 25 W. Alternatively, the first charging power is 25 W, and the second charging power is greater than 25 W. However, the above values of the first and second charging powers are provided for reference only and are not limiting.

As shown in FIGS. 1 and 5, when the wireless charging pad 2 is not placed in the accommodation region 111 and is used alone without the charging base 1, the first connector 13 and the second connector 24 are in a separated state. As shown in FIGS. 2 to 4, when the wireless charging pad 2 is placed in the accommodation region 111 and used together with the charging base 1, the first connector 13 and the second connector 24 are in a mated state.

Third, as shown in step S3 of FIG. 9 and in FIGS. 2 to 4 and 6 to 8, after the first connector 13 and the second connector 24 are mated, when the controller unit 23 detects via a second sensor that the mobile device 200 is not placed on the wireless charging pad 2, the cooling chip 14 and the fan 12 are turned off. When the controller unit 23 detects via the second sensor that the mobile device 200 is placed on the wireless charging pad 2, the cooling chip 14 and the fan 12 are turned on.

In this embodiment, the second sensor may be a current or voltage sensor installed corresponding to the wireless charging coil 22, which determines whether the mobile device 200 is placed on the wireless charging pad 2 by detecting changes in the current or voltage of the current or voltage sensor. Alternatively, the second sensor may be a weight sensor installed corresponding to the accommodation region 111, which determines whether the mobile device 200 is placed on the wireless charging pad 2 by detecting changes in weight, but the second sensor is not limited to these.

As shown in FIGS. 1, 6, and 8, in this embodiment, the first connector 13 is electrically connected to the buck converter 15. In step S3, when the controller unit 23 detects that the mobile device 200 is placed on the wireless charging pad 2, the wireless charging pad 2 provides a voltage to the buck converter 15 through the first connector 13 and the second connector 24. The buck converter 15 then supplies a reduced voltage to the cooling chip 14 and the fan 12.

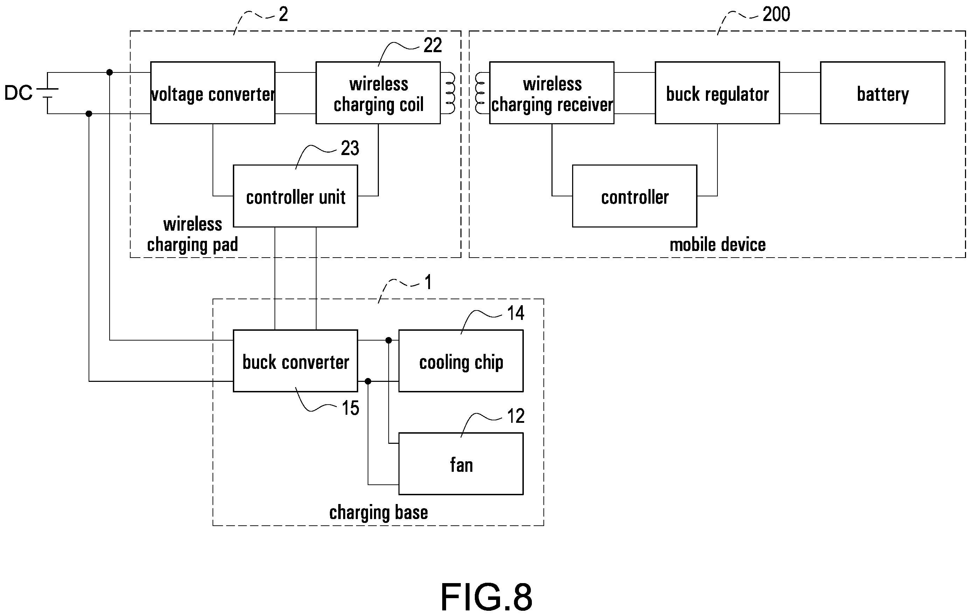

As shown in the circuit diagram of the wireless charging module 10 in FIG. 8, the wireless charging pad 2 further includes a voltage converter for supplying voltage to the wireless charging coil 22 and the controller unit 23. The mobile device 200 includes a wireless charging receiver and a buck regulator that receives the voltage from the wireless charging receiver and steps down the voltage to supply the battery and the controller.

Accordingly, as shown in FIG. 5, the wireless charging pad 2 of the present disclosure may be used alone without the charging base 1, thereby providing the wireless charging module 10 with the advantage of portability. When the wireless charging pad 2 is used alone, it outputs a first charging power to the mobile device 200 that is equal to or less than the second charging power.

Furthermore, as shown in FIGS. 3 and 4, the wireless charging pad 2 may also be used together with the charging base 1. When used in combination with the charging base 1, the wireless charging pad 2 outputs a higher second charging power to the mobile device 200, thereby activating a fast charging mode. Since the charging base 1 is equipped with active heat-dissipating components such as the fan 12 and the cooling chip 14, the heat generated by the high charging power output of the wireless charging pad 2 may be dissipated through the active heat-dissipating components of the charging base 1. This provides the wireless charging module 10 with the advantages of fast charging and high heat-dissipation efficiency.

Accordingly, the wireless charging module 10 of the present disclosure may automatically switch the charging power according to operational requirements, whether the wireless charging pad 2 is used alone or in combination with the charging base 1. At the same time, when operating at a higher charging power, the active heat-dissipating components of the charging base 1 are activated to dissipate heat from the wireless charging pad 2. As a result, the wireless charging module 10 simultaneously provides the advantages of automatically switching charging power according to operational requirements, portability, fast charging, and high heat-dissipation efficiency.

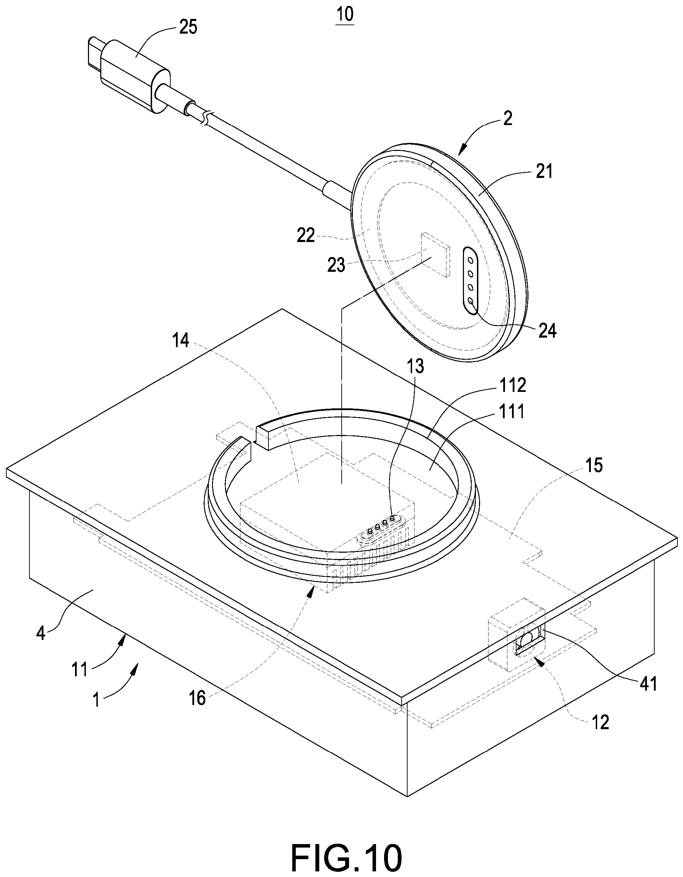

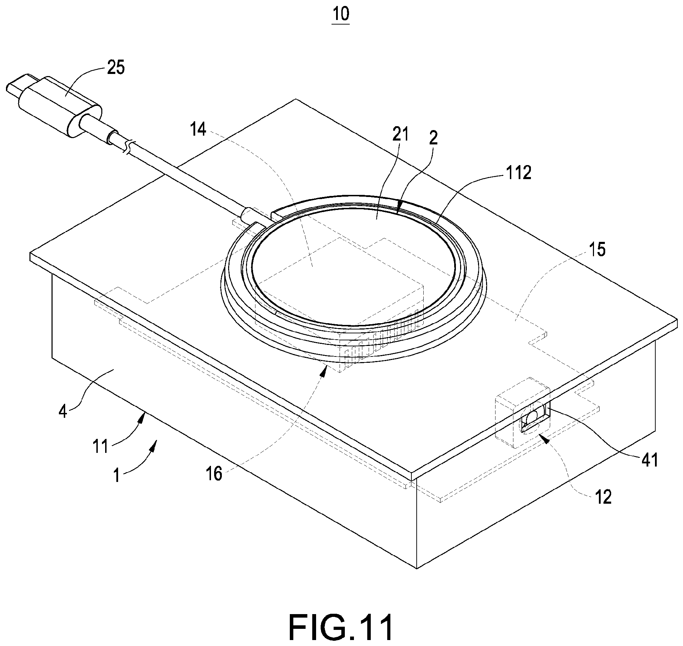

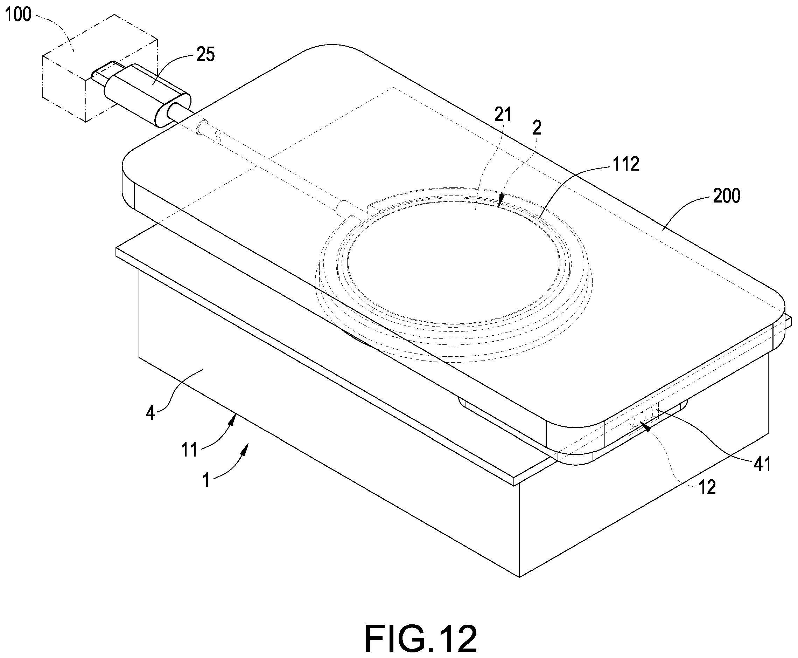

As shown in FIGS. 10 to 13, they illustrate another embodiment of the wireless charging module 10 of the present disclosure. The embodiment shown in FIGS. 10 to 13 is similar to the embodiment shown in FIGS. 1 to 9. The difference between the embodiment of FIGS. 10 to 13 and that of FIGS. 1 to 9 lies in the structure of the charging base 1.

The detailed description is as follows. In this embodiment, the base body 11 is a rectangular base body 4, but this is not limited thereto. The heat-dissipating fin 16 is mounted inside the base body 11 and thermally attached to the cooling chip 14. The heat-dissipating fin 16 is configured to absorb heat from the cooling chip 14 and dissipate it to the surrounding environment. The air inlet 41 and the air outlets 42 are defined oppositely on the outer periphery of the rectangular base body 4. The recessed slot 112 is formed on the top of the rectangular base body 4. The heat-dissipating fin 16 is disposed between the air inlet 41 and the air outlet 42, and the fan 12 is disposed between the air inlet 41 and the heat-dissipating fin 16.

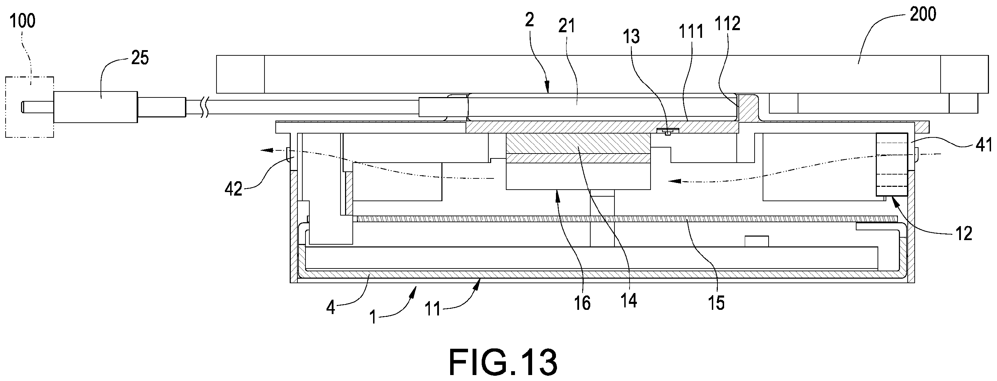

As shown in FIG. 13, in this embodiment, the fan 12 is an axial fan configured to generate an airflow, indicated by dashed lines with arrows in the figure, that sequentially enters the axial fan through the air inlet 41, dissipates heat from the heat-dissipating fin 16 and the cooling chip 14, and then exits through the air outlet 42 to the outside of the rectangular base body 4. Accordingly, the same effects as the embodiment shown in FIGS. 1 to 9 are achieved.

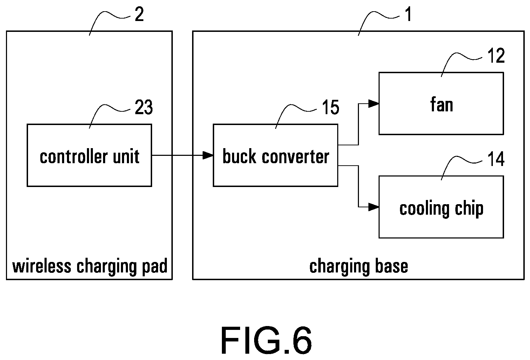

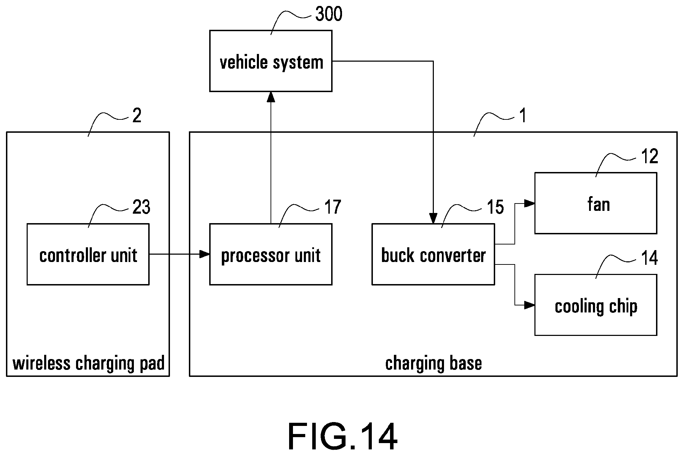

As shown in FIG. 14, another embodiment of the wireless charging module 10 of the present disclosure is illustrated. The embodiment of FIG. 14 is similar to the embodiment shown in FIG. 6. The difference lies in that the wireless charging module 10 in FIG. 14 is applied to a vehicle system 300, and the charging base 1 is integrated with the vehicle system 300.

In this embodiment, the charging base 1 further includes a processor unit 17, and the vehicle system 300 is electrically connected to the buck converter 15. Referring to FIG. 9, in step S3, when the controller unit 23 detects that the mobile device 200 is placed on the wireless charging pad 2, the controller unit 23 first sends a signal to the processor unit 17. The processor unit 17 then sends a signal to the vehicle system 300, which provides a voltage to the buck converter 15. The buck converter 15 then supplies a reduced voltage to the cooling chip 14 and the fan 12. Accordingly, the same effects as those in the embodiment shown in FIGS. 1 to 9 are achieved.

While this disclosure has been described by means of specific embodiments, numerous modifications and variations may be made thereto by those skilled in the art without departing from the scope and spirit of this disclosure set forth in the claims.

## Claims

1. A wireless charging module with power switching for an external power source, comprising:
a charging base comprising a base body, a fan and a first connector mounted to the base body, the base body having an accommodation region, the fan being disposed corresponding to the accommodation region, and the first connector being exposed in the accommodation region; and
a wireless charging pad detachably disposed in the accommodation region, the wireless charging pad comprising a pad body, a wireless charging coil and a controller unit mounted inside the pad body, and a second connector and a third connector mounted outside the pad body, the controller unit being electrically connected to the wireless charging coil, the second connector, and the third connector, the first connector being mated with or separable from the second connector, and the third connector being mated with or separable from the external power source;
wherein when the controller unit detects that the first connector is separated from the second connector, the controller unit controls the wireless charging coil to output a first charging power, and when the controller unit detects that the first connector is mated with the second connector, the controller unit controls the wireless charging coil to output a second charging power, the second charging power being greater than or equal to the first charging power.

2. The wireless charging module with power switching according to claim 1, wherein the charging base further comprises a cooling chip and a buck converter, the fan, the cooling chip, and the step-down circuit being mounted inside the base body, the cooling chip being attached to the accommodation region, and the step-down circuit being electrically connected to the fan and the cooling chip.

3. The wireless charging module with power switching according to claim 2, wherein the base body is provided with a recessed slot, the wireless charging pad being detachably embedded in the recessed slot, and the accommodation region being formed on an inner bottom wall of the recessed slot.

4. The wireless charging module with power switching according to claim 3, wherein the base body is a trapezoidal base body, a side of an outer periphery of the trapezoidal base body being provided with an upright inclined wall and a ventilation opening being disposed at a bottom thereof, the recessed slot being formed on an outer side surface of the upright inclined wall, the charging base further comprising a heat-dissipating fin, the fan and the heat-dissipating fin being fixed to an inner side surface of the upright inclined wall, the heat-dissipating fin being thermally attached to the cooling chip and disposed around a periphery of the fan, and the cooling chip being interposed among the upright inclined wall, the fan, and the heat-dissipating fin, and being exposed to the accommodation region.

5. The wireless charging module with power switching according to claim 3, wherein the base body is a rectangular base body, the charging base further comprising a heat-dissipating fin, the heat-dissipating fin being mounted inside the base body and thermally attached to the cooling chip, an air inlet and an air outlet being defined oppositely on an outer periphery of the rectangular base body, the recessed slot being formed on a top of the rectangular base body, the heat-dissipating fin being disposed between the air inlet and the air outlet, and the fan being disposed between the air inlet and the heat-dissipating fin.

6. The wireless charging module with power switching according to claim 3, wherein the recessed slot comprises a pad-receiving recess having a shape corresponding to the pad body, and a connector-receiving recess having a shape corresponding to the third connector.

7. A control method for a wireless charging module with power switching, applicable to an external power source, comprising a charging base and a wireless charging pad, the charging base comprising an accommodation region and a first connector, the wireless charging pad comprising a wireless charging coil, a controller unit, and a second connector, the first connector being exposed to the accommodation region, the method comprising:
a) electrically connecting the wireless charging pad to the external power source and detachably disposing the wireless charging pad in the accommodation region; and
b) when the controller unit detects that the first connector is separated from the second connector, controlling the wireless charging coil to output a first charging power, and when the controller unit detects that the first connector is mated with the second connector, controlling the wireless charging coil to output a second charging power, the second charging power being greater than or equal to the first charging power.

8. The control method for a wireless charging module with power switching according to claim 7, wherein the method is further applicable to a mobile device, the charging base further comprising a fan and a cooling chip, and wherein, after step b), the method further comprises:
c) after the first connector is mated with the second connector, when the controller unit detects that the mobile device is not placed on the wireless charging pad, turning off the cooling chip and the fan, and when the controller unit detects that the mobile device is placed on the wireless charging pad, turning on the cooling chip and the fan.

9. The control method for a wireless charging module with power switching according to claim 8, wherein the charging base further comprises a buck converter, and in step c), when the controller unit detects that the mobile device is placed on the wireless charging pad (2), the wireless charging pad provides a voltage to the buck converter through the first connector and the second connector, and the buck converter provides a reduced voltage to the cooling chip and the fan.

10. The control method for a wireless charging module with power switching according to claim 8, wherein the method is further applicable to a vehicle system, the charging base further comprising a buck converter and a processor unit, and in step c), when the controller unit detects that the mobile device is placed on the wireless charging pad, the controller unit first sends a signal to the processor unit, the processor unit then sends the signal to the vehicle system, the vehicle system provides a voltage to the buck converter, and the buck converter provides a reduced voltage to the cooling chip and the fan.
